Europäisches Patentamt

European Patent Office

Office européen des brevets

(19)

(11) Veröffentlichungsnummer : **0 077 481**
**B1**

(12) **EUROPÄISCHE PATENTSCHRIFT**

(45) Veröffentlichungstag der Patentschrift :
23.12.87

(21) Anmeldenummer : 82109015.6

(22) Anmeldetag : 29.09.82

(51) Int. Cl.⁴ : **H 01 L 29/06**

(54) **Planares Halbleiterbauelement.**

(30) Priorität : 16.10.81 DE 3141203

(43) Veröffentlichungstag der Anmeldung :
27.04.83 Patentblatt 83/17

(45) Bekanntmachung des Hinweises auf die Patenterteilung : 23.12.87 Patentblatt 87/52

(84) Benannte Vertragsstaaten :
CH DE FR GB IT LI

(56) Entgegenhaltungen :
EP-A- 0 037 115
DE-A- 3 046 749
FR-A- 2 282 723
US-A- 3 767 981
IBM TECHNICAL DISCLOSURE BULLETIN, Band 19,
Nr. 2, Juli 1976, New York (US); C.G.JAMBOTKAR:
"Spaced field plate for increasing planar junction
breakdown voltage"
"Siemens Forschungs- und Entwicklungs-Berichte",
Band 9 (1980), Nr.4, Seite 186

(73) Patentinhaber : **Siemens Aktiengesellschaft Berlin
und München
Wittelsbacherplatz 2
D-8000 München 2 (DE)**

(72) Erfinder : **Stengl, Jens Peer, Ing.grad.
Guntherstrasse 13
D-8000 München 19 (DE)**
Erfinder : **Strack, Helmut, Dr. phil.
Speyerer Strasse 6
D-8000 München 40 (DE)**
Erfinder : **Tihanyi, Jenö, Dr. Ing.
Wolfratshauserstrasse 179b
D-8000 München 71 (DE)**

## Beschreibung

Die Erfindung bezieht sich auf ein Halbleiterbauelement mit einem Halbleiterkörper, bestehend aus einem Substrat vom ersten Leitungstyp und mindestens einer im Substrat planar eingebetteten Zone entgegengesetzten Leitungstyps, mit einer Isolierschicht auf derjenigen Oberfläche, an der die eingebettete Zone liegt, mit einer dieser Zone kontaktierenden Elektrode, mit einem außerhalb dieser Zone am Rand des Halbleiterkörpers auf der Isolierschicht angeordneten Channel-Stopper, der elektrisch mit dem Substrat verbunden ist, und mit einer auf der Isolierschicht angeordneten, zwischen dieser Zone und dem Channel-Stopper liegenden Feldplatte, die elektrisch mit der Zone verbunden ist.

Ein solches Halbleiterbauelement ist z. B. in den « Siemens Forschungs- und Entwicklungs-Berichten », Band 9 (1980), Nr. 4, Seite 186 beschrieben worden. In Fig. 13 dieser Veröffentlichung ist ein MOS-Leistungstransistor mit den eingangs erwähnten Merkmalen gezeigt. Der am Rand des Transistors liegende Channel-Stopper verhindert eine Ausweitung der Raumladungszone bis an den Rand des Substrats. Die Äquipotentiallinien treten dann ausschließlich zwischen Channel-Stopper und Feldplatte durch die Oberfläche des Halbleiterkörpers. Der Channel-Stopper besteht aus einer Aluminiumleiterbahn, die mit dem Substrat kontaktiert ist und die Isolierschicht ein Stück überlappt. Es hat sich gezeigt, daß ein solcher einfacher Channel-Stopper eine scharfe Krümmung der Äquipotentiallinien im Oberflächenbereich des Halbleiterkörpers verursacht. Dies bringt eine hohe Feldstärke im Oberflächenbereich des Halbleiterkörpers mit sich, was zum Oberflächendurchbruch führen kann. Die Durchbruchsspannung an der Oberfläche ist dabei wesentlich geringer als im Halbleiterkörper selbst. Dieses Problem tritt nicht nur bei einem MOS-Leistungstransistor auf, sondern bei allen planaren Halbleiterbauelementen.

Der Erfindung liegt die Aufgabe zugrunde, ein Halbleiterbauelement der eingangs erwähnten Art so weiterzubilden, daß die starke Krümmung der Äquipotentiallinien im Oberflächenbereich des Halbleiterkörpers vermieden wird.

Diese Aufgabe wird dadurch gelöst, daß der Channel-Stopper 6 mindestens zwei Stufen 7, 8 hat, und daß die der genannten Zone 2 jeweils näherliegende Stufe einen größeren Abstand zur Oberfläche des Halbleiterkörpers als die jeweils vorhergehende Stufe hat.

Weiterbildungen der Erfindung sind Gegenstand der Unteransprüche.

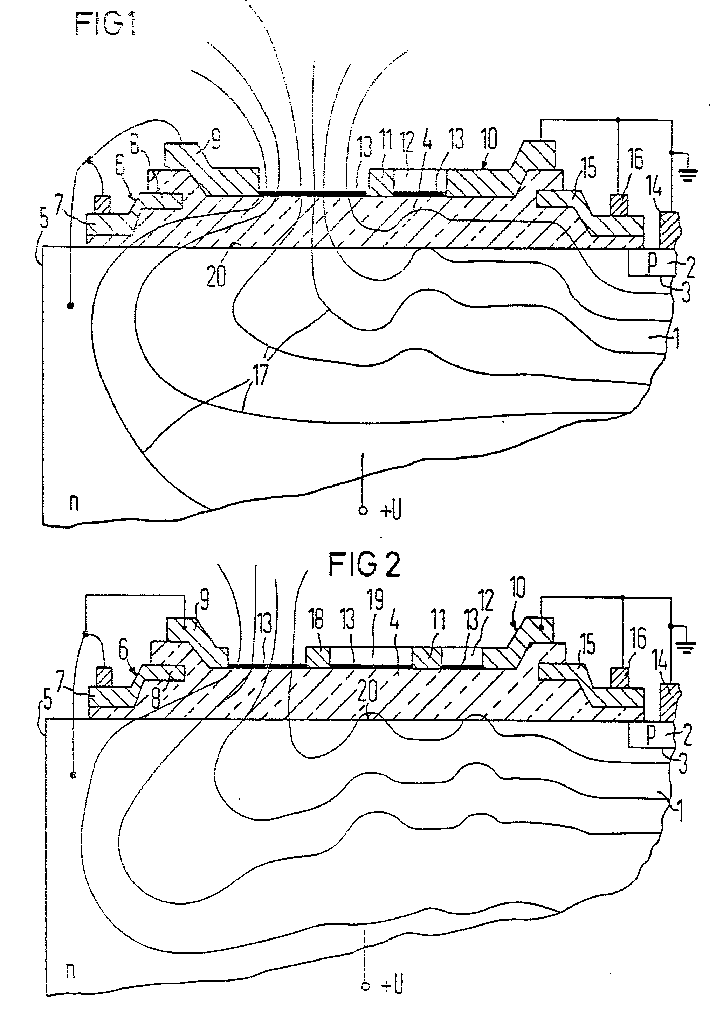

Die Erfindung wird anhand einiger Ausführungsbeispiele in Verbindung mit den Fig. 1 bis 4 näher erläutert. Die Figuren zeigen Querschnitte durch einen Teil der Halbleiterkörper und die Elektroden von vier verschiedenen Ausführungsbeispielen. Gleiche Teile sind mit gleichen Bezugszeichen versehen.

In Fig. 1 ist das Substrat des Halbleiterkörpers mit 1 bezeichnet. In das Substrat ist eine Zone 2 mit dem Substrat emtgegengesetzten Leitungstyp planar eingebettet. Die Zone 2 und das Substrat 1 grenzen an einem pn-Übergang 3 aneinander. Die Oberfläche des Halbleiterkörpers ist mit einer Isolierschicht 4 versehen, die üblicherweise aus Siliciumdioxid SiO$_2$ besteht. Sie überdeckt den pn-Übergang 3 dort, wo er an die Oberfläche des Halbleiterkörpers tritt und erstreckt sich bis nahe an den Rand 5 des Halbleiterkörpers. Am Rand 5 ist ein Channel-Stopper 6 vorgesehen, der auf der Isolierschicht 4 sitzt. Der Channel-Stopper ist elektrisch mit dem Substrat 1 verbunden. Er besteht aus zwei Stufen 7 und 8, wobei die weiter vom Rand 5 entfernte Stufe 8 einen größeren Abstand von der Oberfläche 20 des Halbleiterkörpers hat als die dem Rand benachbarte Stufe 7. Die Stufen des Channel-Stoppers können aus einer einzigen Schicht dotierten Poly-Siliciums bestehen. Andere leitende Materialien sind ebenfalls möglich.

Der Channel-Stopper 6 kann auch aus mehr als zwei Stufen bestehen ; die dritte Stufe hat dann wiederum einen größeren Abstand von der Oberfläche 20 des Halbleiterkörpers als die Stufe 8. Im Ausführungsbeispiel nach Fig. 1 besteht die dritte Stufe aus einer Metallelektrode 9, die die zweite Stufe 8 überlappt. Die Metallelektrode 9 ist ebenfalls mit dem Substrat kontaktiert und bildet damit einen Teil des Channel-Stoppers 6. Auf der Isolierschicht 4 sitzt noch eine Feldplatte 10, deren Zweck weiter unten erläutert wird. Die Feldplatte 10 ist über eine Elektrode 14 mit der Zone 2 elektrisch verbunden.

Bei Anlegen einer Spannung mit der eingezeichneten Polarität wird der pn-Übergang 3 in Sperrichtung vorgespannt. Damit bildet sich eine Raumladungszone aus, deren Äquipotentiallinien mit 17 bezeichnet sind. Bedingt durch den zur Zone 2 hin zunehmenden Abstand des Channel-Stoppers von der Oberfläche 20 weisen die unter dem Channel-Stopper verlaufenden Äquipotentiallinien 17 einen großen Krümmungsradius auf. Das heißt, daß die Feldstärke im Innern des Halbleiterkörpers klein gehalten wird. Außerdem wird erreicht, daß die Äquipotentiallinien in weitem Abstand voneinander durch die Oberfläche des Halbleiterkörpers treten. Das heißt, daß die Oberflächenfeldstärke gering gehalten werden kann. Durch geeignete Dimensionierung ist es möglich, den Oberflächendurchbruch dem Durchbruch im Innern des Halbleiterkörpers stark anzunähern.

Der Verlauf der Äquipotentiallinien zwischen der Zone 2 und dem Channel-Stopper kann durch die oben erwähnte Feldplatte 10 und durch eine Hilfselektrode 15 weiter verbessert werden. Die Hilfselektrode 15 weist einen in Richtung zum Rand 5 des Halbleiterkörpers zunehmenden Abstand auf und überlappt die Zone 2 mit ihrem der Oberfläche 20 am nächsten liegenden Teil. Sie ist durch eine Elektrode 16 mit der Elektrode 14 und der Feldplatte 10 kontaktiert. Die Feldplatte 10 kann aus mehreren Teilen bestehen und eine streifen- oder ringförmige Elektrode 11 aufweisen, die mit der Feldplatte 10 durch einen Steg 12 elektrisch verbunden ist. Die Elektrode 11 beeinflußt dabei die Form der Äquipotentiallinien derart, daß auch im Bereich unter der Feldplatte kleine Krümmungsradien vermieden werden. Die Äquipotentiallinien 17 treten dann durch die Oberfläche der Isolierschicht 4 aus. Zur Passivierung der von Elektroden nicht bedeckten Oberflächenteile der Isolierschicht 4 sind Passivierungsschichten 13 vorgesehen, die z. B. aus aufgedampftem, amorphem Silicium bestehen können.

Das in Fig. 1 gezeigte Ausführungsbeispiel kann etwa die folgenden Abmessungen haben : Abstand der Stufe 7 von der Oberfläche des Halbleiterkörpers 20 = 0,1 $\mu$m ; Abstand der Stufe 8 von der Oberfläche = 0,5 bis 1 $\mu$m ; Mindestabstand der Elektrode 9 von der Oberfläche = 1 bis 2 $\mu$m ; Abstand der Elektrode 9 von der streifenförmigen Elektrode 11 = 3 bis 15 $\mu$m ; Breite der Elektrode 11 = 5 bis 10 $\mu$m ; Abstand Elektrode 11-Feldplatte 10 = 20 bis 50 $\mu$m je nach Sperrspannung ; Abstand der Hilfselektrode 15 entsprechend dem Channel-Stopper 6 ; Dotierung der Zone 2 = $10^{18}$ bis $10^{20}$ cm$^{-3}$ ; Dotierung des Substrats 1 = $2 \cdot 10^{14}$ cm$^{-3}$.

Mit einem solchen Halbleiterbauelement wurde eine Sperrspannung von 1 000 V erreicht, gegenüber einem Halbleiterbauelement mit einem einfachen Channel-Stopper, das lediglich eine Sperrspannung von 700 V erreichte.

Das Halbleiterbauelement nach Fig. 2 unterscheidet sich von dem nach Fig. 1 dadurch, daß der Feldplatte 10 mehrere streifenförmige Elektroden 11 und 18 zugeordnet sind. Die Elektroden 11 und 18 sind durch Stege 13 bzw. 19 mit der Feldplatte 10 verbunden. Auch hier ergeben sich große Krümmungsradien und große Abstände der Äquipotentiallinien beim Durchtritt durch die Oberfläche 20 des Halbleiterkörpers. Besonders günstig wird der Verlauf der Äquipotentiallinien unter den Elektroden 11 und 18 sowie unter der Feldplatte 10 dann, wenn die Elektrode 11 einen kleineren Abstand von der Feldplatte 10 hat als die Elektrode 18 von der Elektrode 11. Der Abstand zwischen 11 und 18 kann dabei zwischen 20 und 50 $\mu$m und der Abstand zwischen 11 und 10 zwischen 10 und 25 $\mu$m liegen. Alle anderen Größen können entsprechend dem Ausführungsbeispiel nach Fig. 1 gewählt werden.

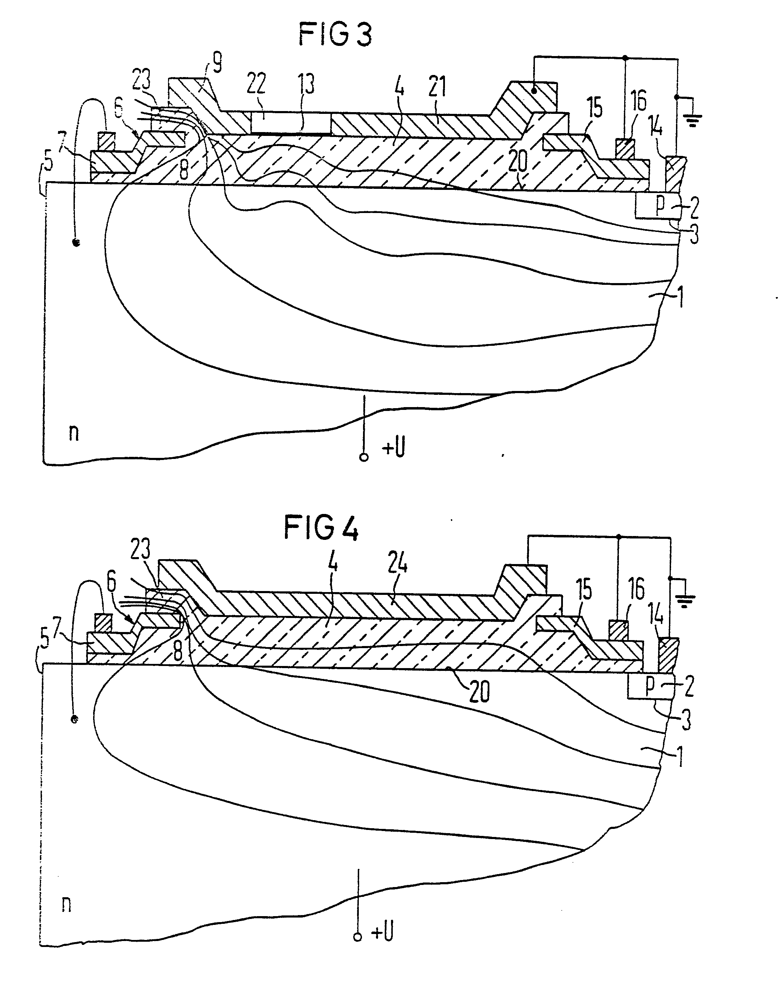

Besonders stabile Kennlinien erhält man bei einem Halbleiterbauelement nach Fig. 3, dessen Isolierschicht 4 fast vollständig bedeckt ist oder bei einem Halbleiterbauelement nach Fig. 4, dessen Isolierschicht 4 vollständig von der Feldplatte bedeckt ist. Beim Bauelement nach Fig. 3 ist die oberste Stufe 9 des Channel-Stoppers durch einen Steg 22 mit der Feldplatte 21 verbunden. Es liegen nur noch die Stufen 7 und 8 des Channel-Stoppers 6 auf Substratpotential. Diese Ausführungsform ist für kleinere Sperrspannungen geeignet, da die Äquipotentiallinien im Zwischenraum 23 zwischen der Feldplatte und der oberen Stufe 8 des Channel-Stoppers 6 zusammengedrängt werden. Das Material der Isolierschicht 4, z. B. Siliciumdioxid, hat zwar eine wesentlich höhere Durchbruchsspannung als Silicium, der relativ geringe Abstand zwischen Feldplatte und Channel-Stopper begrenzt die Anwendbarkeit jedoch auf 200 bis 300 V Sperrspannung. Die von der Feldplatte 21 nicht bedeckten Oberflächenteile der Isolierschicht 4 sind wieder von einer Passivierungsschicht 13 bedeckt, die ebenfalls aus aufgedampftem Silicium bestehen kann. Sehr stabile Kennlinien werden mit dem Ausführungsbeispiel nach Fig. 4 erhalten, bei dem die Feldplatte 24 den Channel-Stopper 6 überlappt. Auch hier werden die Feldlinien im Zwischenraum 23 zwischen Feldplatte 24 und Channel-Stopper 6 zusammengedrängt, so daß diese Ausführungsform ebenfalls auf Sperrspannungen zwischen 200 und 300 V beschränkt bleibt.

Die Erfindung ist für alle planaren Halbleiterbauelemente, z. B. Thyristoren, Bipolartransistoren, MOS-Transistoren und Dioden geeignet. Bei Halbleiterbauelementen mit nur einem einzigen System auf einem Halbleiterchip ist der Channel-Stopper rings um dieses System am Rand des Halbleiterkörpers herum angeordnet. Bei Halbleiterchips mit mehreren Systemen, wie dies z. B. bei Leistungs-MOS-Transistoren und -Thyristoren der Fall ist, liegt der Channel-Stopper jeweils zwischen dem Rand des Halbleiterchips und den dem Rand benachbarten Systemen.

**Patentansprüche**

1. Halbleiterbauelement mit einem Halbleiterkörper, bestehend aus einem Substrat (1) vom ersten Leitungstyp und mindestens einer im Substrat planar eingebetteten Zone (2) entgegengesetzten Leitungstyps, mit einer Isolierschicht (4) auf derjenigen Oberfläche, an der die eingebettete Zone liegt, mit einer diese Zone (2) kontaktierenden Elektrode (14), mit einem außerhalb dieser Zone am Rand des Halbleiterkörpers auf der Isolierschicht (4) angeordneten Channel-Stopper (6), der elektrisch mit dem Substrat verbunden ist, und mit einer auf der Isolierschicht angeordneten, zwischen dieser Zone und dem Channel-Stopper liegenden Feldplatte (10), die elektrisch mit der Zone verbunden ist, dadurch gekennzeichnet, daß der Channel-Stopper (6) mindestens zwei Stufen (7, 8) hat, und daß die der genannten Zone (2) jeweils näherliegende Stufe einen größeren Abstand zur Oberfläche des Halbleiterkörpers als die jeweils vorhergehende Stufe hat.

2. Halbleiterbauelement nach Anspruch 1, dadurch gekennzeichnet, daß der Channel-Stopper (6) aus mehreren, sich überlappenden Teilelektroden (7, 8 ; 9) besteht, die elektrisch miteinander verbunden sind.

3. Halbleiterbauelement nach einem der Ansprüche 1 bis 2, dadurch gekennzeichnet, daß auf der Isolierschicht (4) zwischen der Feldplatte (10) und dem Channel-Stopper (6) mindestens eine weitere streifenförmige Elektrode (11) angeordnet ist, die elektrisch mit der Feldplatte (10) verbunden ist.

4. Halbleiterbauelement nach Anspruch 3, dadurch gekennzeichnet, daß mehrere streifenförmige weitere Elektroden (11, 18) vorgesehen sind, die vom Channel-Stopper (6) ausgehend in Richtung zur Feldplatte (10) in voneinander kleiner werdendem Abstand angeordnet sind.

5. Halbleiterbauelement nach einem der Ansprüche 1 bis 4, dadurch gekennzeichnet, daß die Feldplatte (10) von der Oberfläche (20) des Halbleiterkörpers mindestens den gleichen Mindestabstand hat wie die oberste Stufe (9) des Channel-Stoppers (6).

6. Halbleiterbauelement nach Anspruch 1, dadurch gekennzeichnet, daß die Feldplatte (21, 24) den Channel-Stopper (6) überlappt.

7. Halbleiterbauelement nach Anspruch 6, dadurch gekennzeichnet, daß die Feldplatte (24) eine einteilige Metallschicht ist.

8. Halbleiterbauelement nach Anspruch 7, dadurch gekennzeichnet, daß die Feldplatte (10) aus mehreren in der gleichen Ebene liegenden Metallschichten (11, 18) besteht, die durch Stege (19, 13) miteinander verbunden sind.

### Claims

1. A semiconductor component comprising a semiconductor body, consisting of a substrate (1) of the first conductivity type and at least one zone (2) of the opposite conductivity type embedded in planar manner in the substrate, an insulating layer (4) on that surface in which the embedded zone is arranged, an electrode (14) which contacts said zone (2), a channel-stopper (6) which is arranged on the insulating layer (4) outside of said zone at the edge of the semiconductor body and is electrically connected to the substrate, and a field plate (10) which is arranged on the insulating layer between this zone and the channel-stopper and is electrically connected to the zone, characterised in that the channel-stopper (6) consists of at least two steps (7, 8), and that the step which is in each case closer to the said zone (2) is arranged at a greater distance from the surface of the semiconductor body than the respective preceding step.

2. A semiconductor component as claimed in Claim 1, characterised in that the channel-stopper (6) consists of a plurality of mutually overlapping part-electrodes (7, 8 ; 9) which are electrically connected to one another.

3. A semiconductor component as claimed in one of Claims 1 to 2, characterised in that on the insulating layer (4) between the field plate (10) and the channel-stopper (6), there is arranged at least one further strip-shaped electrode (11) which is electrically connected to the field plate (10).

4. A semiconductor component as claimed in Claim 3, characterised in that a plurality of strip-shaped further electrodes (11, 18) are provided which are arranged at reducing intervals in the direction from the channel-stopper (6) to the field plate (10).

5. A semiconductor component as claimed in one of Claims 1 to 4, characterised in that the field plate (10) is arranged at least at the same minimum distance from the surface (20) of the semiconductor body as the upper step (9) of the channel-stopper (6).

6. A semiconductor component as claimed in Claim 1, characterised in that the field plate (21, 24) overlaps the channel-stopper (6).

7. A semiconductor component as claimed in Claim 6, characterised in that the field plate (24) is a single metal layer.

8. A semiconductor component as claimed in Claim 7, characterised in that the field plate (10) consists of a plurality of metal layers (11, 18) which are arranged in the same plane and which are connected to one another by bridges (19, 13).

### Revendications

1. Composant à semiconducteurs comportant un corps semiconducteur constitué par un substrat (1) possédant le premier type de conductivité et au moins une zone (2) insérée selon le mode planar dans le substrat et possédant le type de conductivité opposé, une couche isolante (4) située sur la surface sur laquelle se trouve disposée la zone insérée, une électrode (14) qui est en contact avec cette zone (2), un dispositif d'arrêt de canal (6), qui est disposé sur la couche isolante (4) à l'extérieur de cette zone, sur le bord du corps semiconducteur, et est relié électriquement au substrat, et une plaque de champ (10) qui est disposée sur la couche isolante, est située entre cette zone et le dispositif d'arrêt de canal et est reliée électriquement à la zone, caractérisé par le fait que le dispositif d'arrêt de canal (6) comporte au moins deux étages (7, 8) et que l'étage, qui est respectivement le plus rapproché de ladite zone (2), est à une plus grande distance de la surface du corps semiconducteur que l'étage respectivement précédent.

2. Composant à semiconducteurs suivant la revendication 1, caractérisé par le fait que le dispositif d'arrêt de canal (6) est constitué par plusieurs électrodes partielles (7, 8 ; 9), qui se chevauchent et sont reliées électriquement entre elles.

3. Composant à semiconducteurs suivant l'une des revendications 1 et 2, caractérisé par le fait que sur la couche isolante (4) se trouve disposée, entre la plaque de champ (10) et le dispositif d'arrêt de canal (6), au moins une autre électrode en forme de bande (11), qui est reliée électriquement à la plaque de champ.

4. Composant à semiconducteurs suivant la revendication 3, caractérisé par le fait qu'il est prévu plusieurs électrodes supplémentaires en forme de bandes (11, 18), qui sont disposées à des intervalles respectifs de plus en plus faibles à partir du dispositif d'arrêt de canal (6) en direction de la plaque de champ (10).

5. Composant à semiconducteurs selon l'une des revendications 1 à 4, caractérisé par le fait que la plaque de champ (10) est, par rapport à la surface (20) du corps semiconducteur, à une distance égale au moins à la même distance minimale que l'étage le plus élevé (9) du dispositif d'arrêt de canal (6).

6. Composant à semiconducteurs suivant la revendication 1, caractérisé par le fait que la plaque de champ (21, 24) est en chevauchement sur le dispositif d'arrêt de canal (6).

7. Composant à semiconducteurs suivant la revendication 6, caractérisé par le fait que la plaque de champ (24) est une couche métallique d'un seul tenant.

8. Composant à semiconducteurs suivant la revendication 7, caractérisé par le fait que la plaque de champ (10) est constituée par plusieurs couches métalliques (11, 18), qui sont situées dans un même plan et sont reliées entre elles par des barrettes (19, 13).

FIG 1

FIG 2

## FIG 3

## FIG 4